# EUROPEAN PATENT SPECIFICATION

(11) **EP 3 327 295 B1**
(45) Date of publication and mention of the grant of the patent: **11.08.2021**
(21) Application number: 17203404.3
(22) Date of filing: 23.11.2017
(51) Int. Cl.: F04D 33/00, F04D 29/40, F04D 25/08, F04B 45/047, H05K 7/20, H01L 23/467, H01L 41/09

(54) **AIR-COOLING HEAT DISSIPATION DEVICE**
LUFTKÜHLUNGSWÄRMEABLEITUNGSVORRICHTUNG
DISPOSITIF DE DISSIPATION DE CHALEUR À REFROIDISSEMENT PAR AIR

(30) Priority: 24.11.2016 TW 105138665
(43) Date of publication of application: 30.05.2018
(73) Proprietor: Microjet Technology Co., Ltd, Hsinchu (TW)
(72) Inventor: Chen, Shih-Chang, Hsinchu (TW); Liao, Jia-Yu, Hsinchu (TW); Han, Yung-Lung, Hsinchu (TW); Huang, Chi-Feng, Hsinchu (TW)
(74) Representative: 2K Patentanwälte Blasberg Kewitz & Reichel

(56) References cited:
- EP-A1- 2 485 321
- EP-A1- 2 998 582
- WO-A1-03/015488
- US-A1- 2007 119 573
- US-A1- 2008 151 501
- US-A1- 2014 090 819

## Description

### FIELD OF THE INVENTION

The present invention relates to an air-cooling heat dissipation device, and more particularly to an air-cooling heat dissipation device using an air pump to produce an air flow to remove heat.

### BACKGROUND OF THE INVENTION

With increasing development of science and technology, the trends of designing electronic devices such as portable computers, tablet computers, industrial computers, portable communication devices or video players are designed toward minimization, easy portability and high performance. Generally, the limited space inside the electronic device is equipped with various high-integration or high-power electronic components for increasing the computing speed and the function of the electronic device, thus generating a great deal of heat during operations. Consequently, the temperature inside the device is increased and high temperature is harmful to the components. Since the electronic device is usually designed as possible as in slim, flat and succinct appearance, it has insufficient inner space for dissipating the waste heat. In case that the heat is not effectively dissipated away, the electronic components of the electronic device are adversely affected by the heat and the high temperature may result in the interference of operation or damaged of the device.

Generally, there are two types of the heat-dissipating mechanisms used in the electronic device to solve such problem, which are known as active heat-dissipating mechanism and passive heat-dissipating mechanism. The active heat-dissipating mechanism is usually presented as an axial fan or a blower, disposed within the electronic device, which can generate an air flow through the space inside the electronic device that dissipating the waste heat. However, the axial fan and the blower are noisy during operation. In addition, they are bulky and have short life span and not suitable to be used in the small-sized, portable electronic device.

WO03015488 A1 discloses a thermo-electro sub-assembly according to the preamble of claim 1, comprising a gas supply, a first duct, a first heatsink adjacent a first device, a second duct, and a second heat sink adjacent a second device. The first duct provides a passageway for delivering pressurized gas from the gas supply to the first heat sink. The duct may include a plurality of vanes for reducing the turbulence and air boundary separation within the duct. The first heatsink is in thermal communication with a first heat-producing device such as a microprocessor. In a preferred embodiment the heatsink comprises an axial shaped folded fin heatsink. The second duct is used to provide a pathway for the air leaving the first heatsink and delivers the air to the second heatsink. The second duct may also include a plurality of vanes for reducing turbulence and boundary flow separation within the second duct. EP2485321 A1 relates to an electrical connector comprising a housing. The connector comprises an arrangement configured to displace a temperature controlling medium and at least one opening in said housing for transporting said temperature controlling medium displaced by said arrangement through said opening

US2008151501 A1 discloses an electronic apparatus having a main body formed as a plate structure, and including a circuit board, circuit elements mounted on the circuit board, and a cooling structure for cooling the circuit elements. The circuit elements include a heat generating element. The cooling structure includes a heat spreader, cooling fins integrally formed with the heat spreader, an air inlet, an air outlet, and a fan device for generating cooling air flowing from the air inlet to the air outlet. The heat spreader is placed above the circuit board and thermally joined to the heat generating element mounted on the circuit board. The cooling fins extend toward the circuit board to provide a plurality of air passages between the circuit board and the heat spreader. The air inlet and outlet communicate with each other through the air passages.

US2014090819 A1 discloses a heat dissipation device including a fan module, a first plate structure and a fin assembly. The fan module includes a fan outlet. The first plate structure is disposed at the fan outlet. The thermal conductance of the first plate structure is above 100 W/(mK). The first plate structure includes a heat-absorbing and a heat-dissipation surface. The heat-absorbing surface includes a heat-absorbing region in thermal contact with a heat source. The heat-dissipation surface includes a heat-dissipation region. The fin assembly is disposed on the heat-dissipation surface and in thermal contact with the heat-dissipation surface. The fan module is adapted to exhaust an air flow flowing above the heat-dissipation surface via the fan outlet. The air flow flows through the heat-dissipation region before through the fin assembly. The distance between the fan outlet and the heat-dissipation region is greater than the distance between the fan outlet and the fin assembly.

On the other hand, electronic components are generally fixed on a printed circuit board (PCB) by means of surface mount technology (SMT) or selective soldering technology. The electronic components would readily come off from the PCB board due to exposure of high temperature. Moreover, most electronic components would be damaged by high temperature. In other words, high temperature not only impairs the stability of performance of the electronic components, but also shortens the life span of the electronic components.

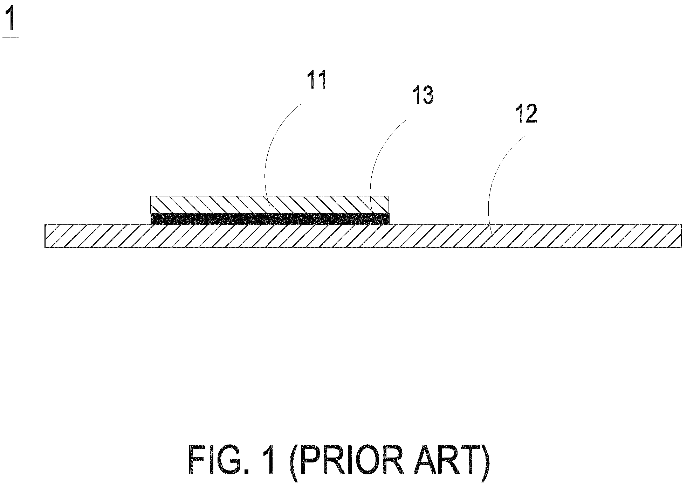

FIG. 1 is a schematic view illustrating a conventional heat-dissipating mechanism as the passive heat-dissipating mechanism. As shown in FIG. 1, the conventional heat-dissipating mechanism 1 provides a thermal conduction plate 12 attaching on a surface of an electronic component 11 by thermal adhesive 13. Therefore, the thermal adhesive 13 and the thermal conduction plate 12 form a thermal conduction path by which the waste heat generated by the electronic component 11 can be conducted away and then dissipated by convection. However, the heat dissipating efficiency of the conventional heat-dissipating mechanism 1 is usually insufficient, and thus the applications of the conventional heat-dissipating mechanism 1 are limited.

Therefore, there is a need of providing an air-cooling heat dissipation device with improved performance as well as compact size to substitute the conventional technologies.

### SUMMARY OF THE INVENTION

The present disclosure relates to an air-cooling heat dissipation device according to claim 1 for being applied to an electronic device that can remove heat from the electronic component of the electronic device by providing lateral heat convection. The air-cooling heat dissipation device includes a main body and an air pump, wherein the main body includes a top surface and an opposing bottom surface while two lateral walls are both connected therebetween. A first airflow-guiding chamber and a second airflow-guiding chamber are separately arranged in the main body and plural communication grooves are adapted to provide access therebetween. An introduction opening is formed in the top surface and in communication with the first airflow-guiding chamber. Plural airflow-exiting grooves are formed in the lateral wall which is beside the second airflow-guiding chamber and provide access between the second airflow-guiding chamber and exterior surroundings. The air pump is disposed on the main body as sealing the edge of the introduction opening. When the air pump is enabled, it creates an air flow passing along a path staring from the introduction opening, sequentially passing the first airflow-guiding chamber, the communication grooves, the second airflow-guiding chamber, the airflow-exiting grooves, and extending to outside. Since the electronic component is positioned by the path in the second airflow-guiding chamber, the air flow removes heat from the electronic component. Such assembly is beneficial to keep the electronic device in compact size, meanwhile, the heat dissipating efficiency is enhanced and the unacceptable noise is prevented.

The air-cooling heat dissipation device according to some embodiments has a temperature controlling function. The operations of the air pump are controlled according to the temperature changes of the electronic component of the electronic device. Consequently, the life span of the air pump can be prolonged.

The above contents of the present invention will become more readily apparent to those ordinarily skilled in the art after reviewing the following detailed description and accompanying drawings, in which:

### BRIEF DESCRIPTION OF THE DRAWINGS

FIG. 1 is a schematic view illustrating a conventional heat-dissipating mechanism;
FIG. 2A is a schematic perspective view illustrating the structure of an air-cooling heat dissipation device according to a first embodiment of the present invention;
FIG. 2B is a schematic cross-sectional view illustrating the air-cooling heat dissipation device of FIG. 2A and taken along the line AA;

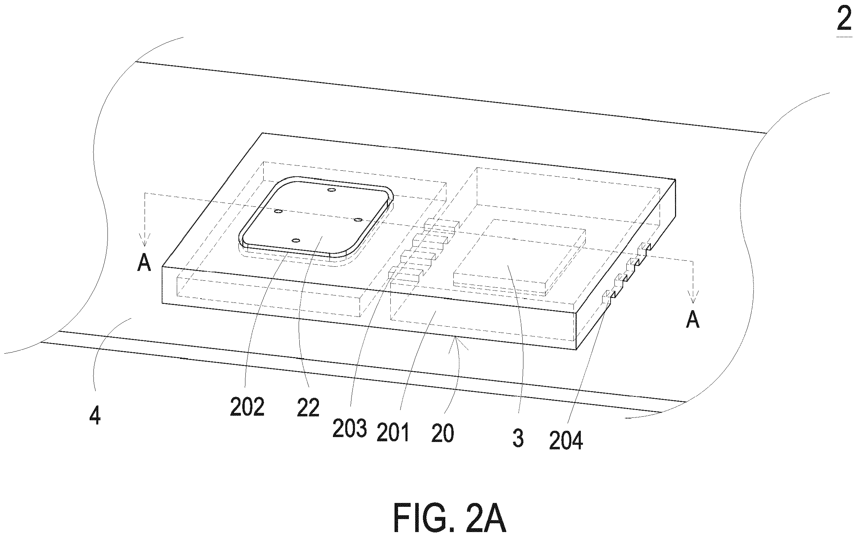

FIG. 2A is a schematic perspective view illustrating the structure of an air-cooling heat dissipation device according to a first embodiment of the present invention;

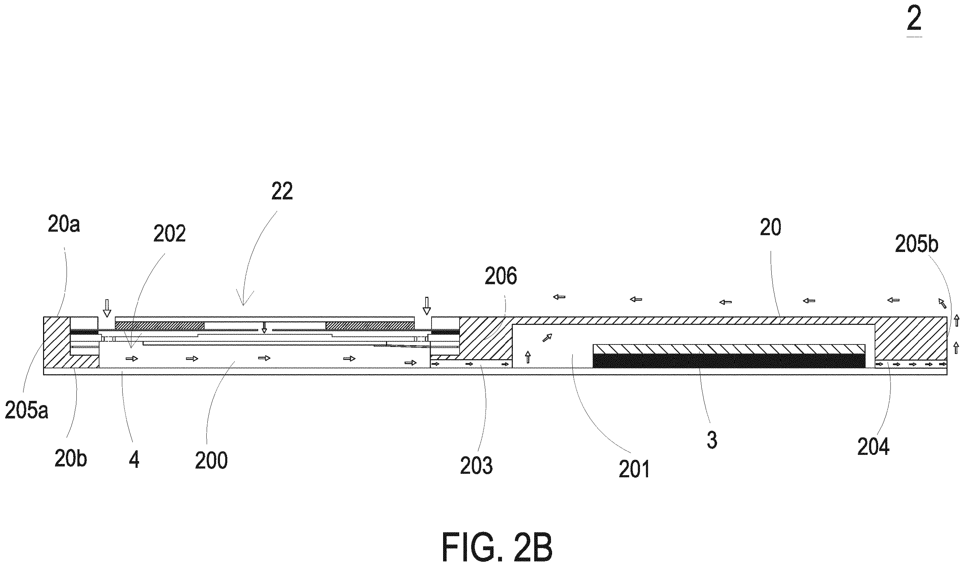

FIG. 2B is a schematic cross-sectional view illustrating the air-cooling heat dissipation device of FIG. 2A and taken along the line AA;

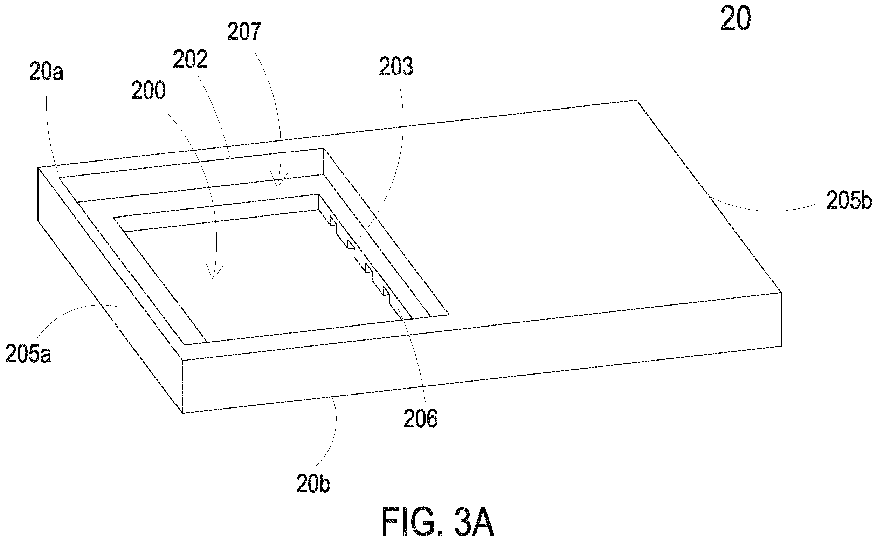

FIG. 3A is a schematic perspective view illustrating a main body of the air-cooling heat dissipation device as shown in FIG. 2A;

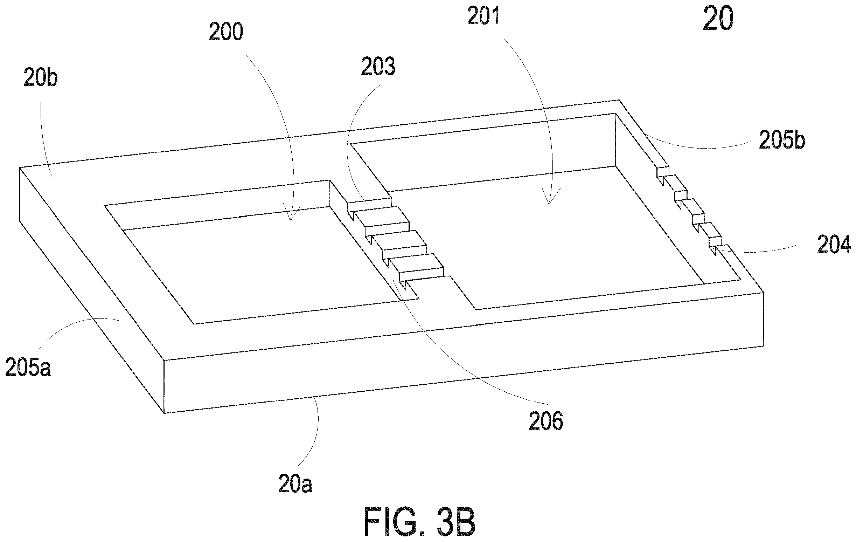

FIG. 3B is a schematic perspective view illustrating the main body of FIG. 3A and taken along another viewpoint;

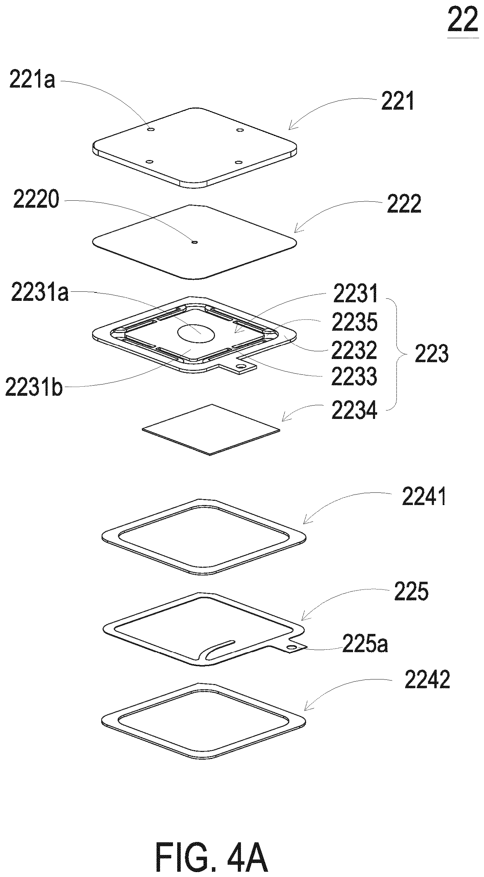

FIG. 4A is a schematic exploded view illustrating an air pump used in the air-cooling heat dissipation device of the present invention;

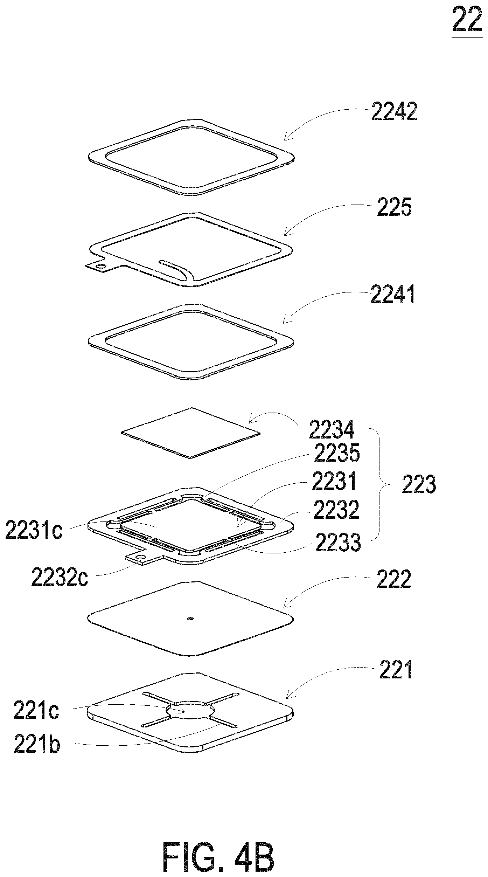

FIG. 4B is a schematic exploded view illustrating the air pump of FIG. 4A and taken along another viewpoint;

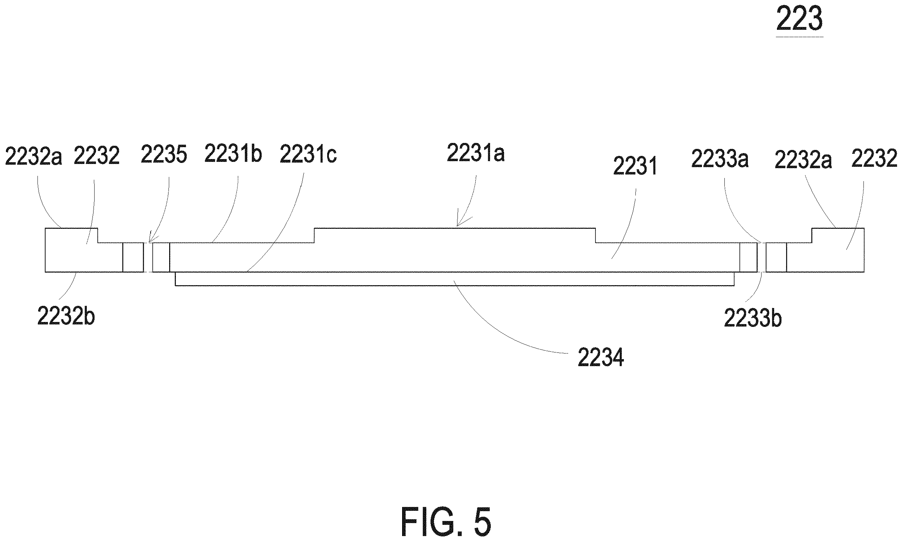

FIG. 5 is a schematic cross-sectional view illustrating a piezoelectric actuator of the air pump as shown in FIGS. 4A and 4B;

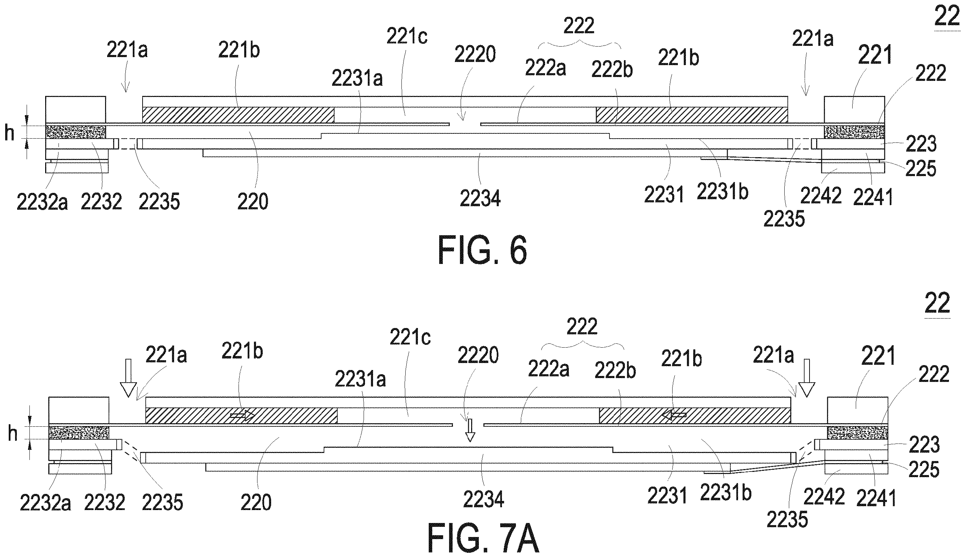

FIG. 6 is a schematic cross-sectional view illustrating the air pump as shown in FIGS. 4A and 4B;
FIGS. 7A to 7E schematically illustrate the actions of the air pump of FIGS. 4A and 4B; and

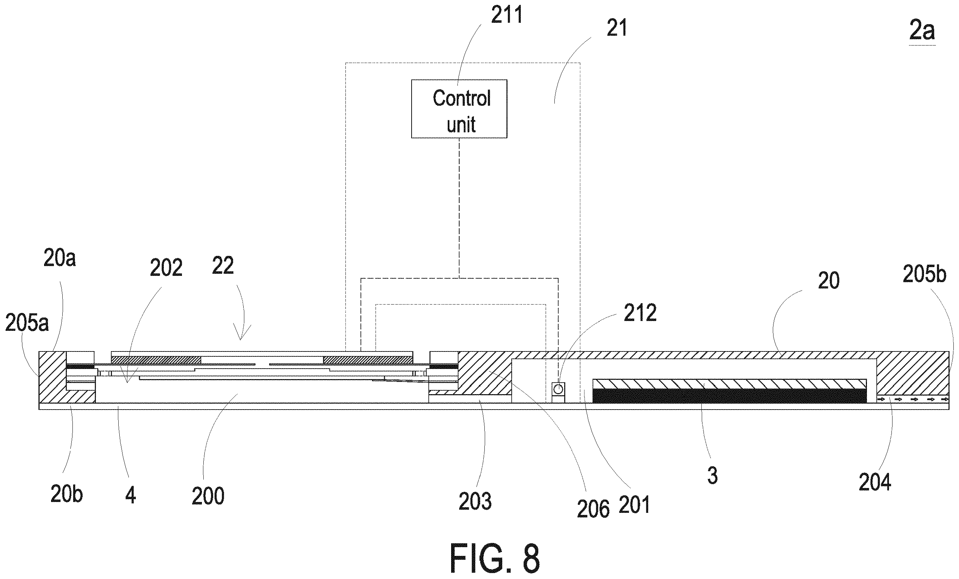

FIG. 8 is a schematic cross-sectional view illustrating an air-cooling heat dissipation device according to a second embodiment of the present invention.

### DETAILED DESCRIPTION OF THE PREFERRED EMBODIMENT

The present invention will now be described more specifically with reference to the following embodiments. It is to be noted that the following descriptions of preferred embodiments of this invention are presented herein for purpose of illustration and description only, the scope of the invention being defined by the appended claims.

FIG. 2A is a schematic perspective view illustrating the structure of an air-cooling heat dissipation device according to a first embodiment of the present invention. FIG. 2B is a schematic cross-sectional view illustrating the air-cooling heat dissipation device of FIG. 2A and taken along the line AA. FIG. 3A is a schematic perspective view illustrating a main body of the air-cooling heat dissipation device as shown in FIG. 2A. FIG. 3B is a schematic perspective view illustrating the main body of FIG. 3A and taken along another viewpoint.

Please refer to FIGS. 2A, 2B and 3. The air-cooling heat dissipation device 2 is applied to an electronic device to remove the heat from an electronic component 3 of the electronic device. An example of the electronic device includes but is not limited to a portable computer, tablet computer, an industrial computer, a portable communication device or video player. The air-cooling heat dissipation device 2 comprises a main body 20 and an air pump 22. The main body 20 comprises a top surface 20a, a bottom surface 20b, a first airflow-guiding chamber 200, a second airflow-guiding chamber 201, an introduction opening 202, plural communication grooves 203, plural airflow-exiting grooves 204, a first lateral wall 205a, a second lateral wall 205b, and a separation wall 206.

The first lateral wall 205a and the second lateral wall 205b are connected between the top surface 20a and the bottom surface 20b. The introduction opening 202 is formed in the top surface 20a and in communication with the first airflow-guiding chamber 200. The first airflow-guiding chamber 200 runs through the bottom surface 20b. The second airflow-guiding chamber 201 is concavely formed in the bottom surface 20b of the main body 20. The first airflow-guiding chamber 200 and the second airflow-guiding chamber 201 are arranged between the first lateral wall 205a and the second lateral wall 205b. Moreover, the first airflow-guiding chamber 200 and the second airflow-guiding chamber 201 are separated from each other by the separation wall 206.

In some embodiments the air-cooling heat dissipation device 2 further comprises a receiving part 207, which is a recess formed in the top surface 20a and arranged around the introduction opening 202. The air pump 22 is fitted to the receiving part 207 to be disposed on the main body 20.

The plural communication grooves 203 are formed in the separation wall 206. The first airflow-guiding chamber 200 and the second airflow-guiding chamber 201 are in communication with each other through the plural communication grooves 203. Moreover, the plural airflow-exiting grooves 204 are formed in the second lateral wall 205b and in communication with the second airflow-guiding chamber 201. The air in the second airflow-guiding chamber 201 can be discharged to the outside of the air-cooling heat dissipation device 2 through the airflow-exiting grooves 204. The air pump 22 is fitted to the receiving part 207 of the main body 20 and seals the edge of the introduction opening 202. Since the air pump 22 is fitted to the receiving part 207 (e.g., the recess), the overall height of the air-cooling heat dissipation device 2 is reduced. When the air pump 22 is enabled, the ambient air is introduced into the first airflow-guiding chamber 200 of the main body 20 through the introduction opening 202, and transferred to the second airflow-guiding chamber 201 through the communication grooves 203. Consequently, the lateral airflow is provided to remove heat from the electronic component 3. After the heat has exchanged, the heated air is discharged to the exterior surroundings through the plural airflow-exiting grooves 204. Consequently, the heat dissipation of the electronic component 3 is achieved. It is noted that numerous modifications and alterations may be made within the scope of the claims. For example, in another embodiment, the main body 20 is not equipped with the receiving part 207. That is, the air pump 22 is directly disposed on the top surface 20a of the main body 20 as sealing the edge of the introduction opening 202. Under this circumstance, the air-cooling heat dissipation device 2 is also effective to cool the electronic component 3.

In this embodiment, the electronic component 3 is disposed on a supporting substrate 4. Preferably but not exclusively, the supporting substrate 4 is a printed circuit board. The supporting substrate 4 is coupled with the bottom surface 20b of the main body 20. Consequently, the electronic component 3 is accommodated within the second airflow-guiding chamber 201 of the main body 20.

In an embodiment, the air pump 22 is a piezoelectric air pump for driving the airflow. The bottom surface 20b of the main body 20 is attached on the supporting substrate 4. In other words, the supporting substrate 4 is covered by and connected with the combination of the main body 20 and the air pump 22. Consequently, the electronic component 3 is accommodated within the second airflow-guiding chamber 201 of the main body 20. Since the introduction opening 202 is enclosed by the air pump 22 and the bottom side of the first airflow-guiding chamber 200 is enclosed by the supporting substrate 4, an airflow channel is defined by the introduction opening 202, the first airflow-guiding chamber 200, the plural communication grooves 203, the second airflow-guiding chamber 201 and the airflow-exiting grooves 204 collaboratively. Since the introduced air is guided by the airflow channel to remove the heat of the electronic component 3, the heat dissipating efficiency is enhanced. It is noted that numerous modifications and alterations may be made within the scope of the claims. For example, the type of the airflow channel may be varied according to the practical requirement.

The air pump 22 is used for driving the airflow. As shown in FIG. 2B, after the air is driven by the air pump 22 and introduced into the first airflow-guiding chamber 200 through the introduction opening 202, the introduced air is transferred to the second airflow-guiding chamber 201 through the communication grooves 203 and exchanges heat with the electronic component 3 positioned in the second airflow-guiding chamber 201. Also, the introduced air pushes the air initially filled in the second airflow-guiding chamber 201 to move quickly, such that the heated air is discharged to the exterior surroundings of the air-cooling heat dissipation device 2 through the airflow-exiting grooves 204 of the main body 20. During the operation of the air pump 22, external air is continuously fed into the main body 20, and waste heat from the electronic component 3 is continuously removed by the introduced air. Under this circumstance, the performance stability and the life span of the electronic component 3 are increased.

FIG 4A is a schematic exploded view illustrating an air pump used in the air-cooling heat dissipation device of the present invention. FIG. 4B is a schematic exploded view illustrating the air pump of FIG. 4A and taken along another viewpoint. FIG. 5 is a schematic cross-sectional view illustrating a piezoelectric actuator of the air pump as shown in FIGS. 4A and 4B. FIG. 6 is a schematic cross-sectional view illustrating the air pump as shown in FIGS. 4A and 4B. Please refer to FIGS. 4A, 4B, 5 and 6. The air pump 22 is a piezoelectric air pump. Moreover, the air pump 22 comprises a gas inlet plate 221, a resonance plate 222, a piezoelectric actuator 223, a first insulation plate 2241, a conducting plate 225 and a second insulation plate 2242. The piezoelectric actuator 223 is aligned with the resonance plate 222. The gas inlet plate 221, the resonance plate 222, the piezoelectric actuator 223, the first insulation plate 2241, the conducting plate 225 and the second insulation plate 2242 are stacked on each other sequentially. After the above components are combined together, the cross-sectional view of the resulting structure of the air pump 22 is shown in FIG 6.

The gas inlet plate 221 comprises at least one inlet 221a. Preferably but not exclusively, the gas inlet plate 221 comprises four inlets 221a. The inlets 221a run through the gas inlet plate 221. In response to the action of the atmospheric pressure, the air is introduced into the air pump 22 through the inlets 221a. Moreover, at least one convergence channel 221b is formed on a first surface of the gas inlet plate 221, and is in communication with the at least one inlet 221a in a second surface of the gas inlet plate 22. Moreover, a central cavity 221c is located at the intersection of the four convergence channels 221b. The central cavity 221c is in communication with the at least one convergence channel 221b, such that the gas entered by the inlets 221a would be introduced into the at least one convergence channel 221b and is guided to the central cavity 221c. Consequently, the air can be transferred by the air pump 22. In this embodiment, the at least one inlet 221a, the at least one convergence channel 221b and the central cavity 221c of the gas inlet plate 221 are integrally formed. The central cavity 221c is a convergence chamber for temporarily storing the air. Preferably but not exclusively, the gas inlet plate 221 is made of stainless steel. In some embodiments, the depth of the convergence chamber defined by the central cavity 221c is equal to the depth of the at least one convergence channel 221b. The resonance plate 222 is made of a flexible material, which is preferably but not exclusively copper. The resonance plate 222 further has a central aperture 2220 corresponding to the central cavity 221c of the gas inlet plate 221 that providing the gas for flowing through.

The piezoelectric actuator 223 comprises a suspension plate 2231, an outer frame 2232, at least one bracket 2233 and a piezoelectric plate 2234. The piezoelectric plate 2234 is attached on a first surface 2231c of the suspension plate 2231. In response to an applied voltage, the piezoelectric plate 2234 would be subjected to a deformation. When the piezoelectric plate 2233 is subjected to the deformation, the suspension plate 2231 is subjected to a curvy vibration. The at least one bracket 2233 is connected between the suspension plate 2231 and the outer frame 2232, while the two ends of the bracket 2233 are connected with the outer frame 2232 and the suspension plate 2231 respectively that the bracket 2233 can elastically support the suspension plate 2231. At least one vacant space 2235 is formed between the bracket 2233, the suspension plate 2231 and the outer frame 2232. The at least one vacant space 2235 is in communication with the introduction opening 202 for allowing the air to go through. The type of the suspension plate 2231 and the outer frame 2232, and the type and the number of the at least one bracket 2233 may be varied according to the practical requirements. The outer frame 2232 is arranged around the suspension plate 2231. Moreover, a conducting pin 2232c is protruding outwardly from the outer frame 2232 so as to be electrically connected with an external circuit (not shown).

As shown in FIG. 5, the suspension plate 2231 has a bulge 2231a that makes the suspension plate 2231 a stepped structure. The bulge 2231a is formed on a second surface 2231b of the suspension plate 2231. The bulge 2231b may be a circular convex structure. A top surface of the bulge 2231a of the suspension plate 2231 is coplanar with a second surface 2232a of the outer frame 2232, while the second surface 2231b of the suspension plate 2231 is coplanar with a second surface 2233a of the bracket 2233. Moreover, there is a drop of specified amount from the bulge 2231a of the suspension plate 2231 (or the second surface 2232a of the outer frame 2232) to the second surface 2231b of the suspension plate 2231 (or the second surface 2233a of the bracket 2233). A first surface 2231c of the suspension plate 2231, a first surface 2232b of the outer frame 2232 and a first surface 2233b of the bracket 2233 are coplanar with each other. The piezoelectric plate 2234 is attached on the first surface 2231c of the suspension plate 2231. The suspension plate 2231 may be a square plate structure with two flat surfaces but the type of the suspension plate 2231 may be varied according to the practical requirements. In this embodiment, the suspension plate 2231, the at least bracket 2233 and the outer frame 2232 are integrally formed and produced by using a metal plate (e.g., a stainless steel plate). In an embodiment, the length of the piezoelectric plate 2234 is smaller than the length of the suspension plate 2231. In another embodiment, the length of the piezoelectric plate 2234 is equal to the length of the suspension plate 2231. Similarly, the piezoelectric plate 2234 is a square plate structure corresponding to the suspension plate 2231.

In the air pump 22, the first insulation plate 2241, the conducting plate 225 and the second insulation plate 2242 are stacked on each other sequentially and located under the piezoelectric actuator 223. The profiles of the first insulation plate 2241, the conducting plate 225 and the second insulation plate 2242 substantially match the profile of the outer frame 2232 of the piezoelectric actuator 223. The first insulation plate 2241 and the second insulation plate 2242 are made of an insulating material (e.g. a plastic material) for providing insulating efficacy. The conducting plate 225 is made of an electrically conductive material (e.g. a metallic material) for providing electrically conducting efficacy. Moreover, the conducting plate 225 has a conducting pin 225a so as to be electrically connected with an external circuit (not shown).

In an embodiment, the gas inlet plate 221, the resonance plate 222, the piezoelectric actuator 223, the first insulation plate 2241, the conducting plate 225 and the second insulation plate 2242 of the air pump 22 are stacked on each other sequentially. Moreover, there is a gap h between the resonance plate 222 and the outer frame 2232 of the piezoelectric actuator 223, which is formed and maintained by a filler (e.g. a conductive adhesive) inserted therein in this embodiment. The gap h ensures the proper distance between the bulge 2231a of the suspension plate 2231 and the resonance plate 222, so that the contact interference is reduced and the generated noise is largely reduced. In some embodiments, the height of the outer frame 2232 of the piezoelectric actuator 223 is increased, so that the gap is formed between the resonance plate 222 and the piezoelectric actuator 223.

In an embodiment, the resonance plate 222 comprises a movable part 222a and a fixed part 222b. After the gas inlet plate 221, the resonance plate 222 and the piezoelectric actuator 223 are combined together, a convergence chamber for converging the air is defined by the movable part 222a of the resonance plate 222 and the gas inlet plate 211 collaboratively. Moreover, a first chamber 220 is formed between the resonance plate 222 and the piezoelectric actuator 223 for temporarily storing the air. Through the central aperture 2220 of the resonance plate 222, the first chamber 220 is in communication with the central cavity 221c of the gas inlet plate 221. The peripheral regions of the first chamber 220 are in communication with the underlying introduction opening 202 through the vacant space 2235 between the brackets 2233 of the piezoelectric actuator 223.

FIGS. 7A to 7E schematically illustrate the actions of the air pump of FIGS. 4A and 4B. Please refer to FIG. 6 and 7A to 7E. The actions of the air pump will be described as follows. When the air pump 22 is enabled, the piezoelectric actuator 223 is vibrated along a vertical direction in a reciprocating manner by using the bracket 2233 as the fulcrums. The resonance plate 222 except for the part of it fixed on the gas inlet plate 221 is hereinafter referred as a movable part 222a, while the rest is referred as a fixed part 222b. Since the resonance plate 222 is light and thin, the movable part 222a vibrates along with the piezoelectric actuator 223 because of the resonance of the piezoelectric actuator 223. In other words, the movable part 222a is reciprocated and subjected to a curvy deformation. When the piezoelectric actuator 223 is vibrated downwardly, the movable part 222a of the resonance plate 222 is subjected to the curvy deformation because the movable part 222a of the resonance plate 222 is pushed by the air and vibrated in response to the piezoelectric actuator 223. In response to the downward vibration of the piezoelectric actuator 223, the air is fed into the at least one inlet 221a of the gas inlet plate 221. Then, the air is transferred to the central cavity 221c of the gas inlet plate 221 through the at least one convergence channel 221b. Then, the air is transferred through the central aperture 2220 of the resonance plate 222 corresponding to the central cavity 221c, and introduced downwardly into the first chamber 220. As the piezoelectric actuator 223 is enabled, the resonance of the resonance plate 222 occurs. Consequently, the resonance plate 222 is also vibrated along the vertical direction in the reciprocating manner.

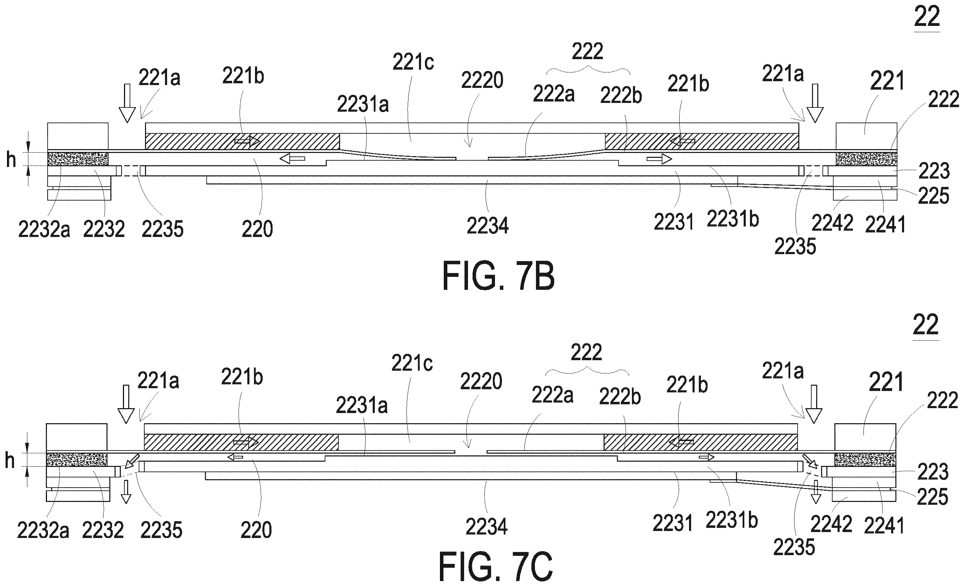

As shown in FIG. 7B, during the vibration of the movable part 222a of the resonance plate 222, the movable part 222a moves down till bring contacted with the bulge 2231a of the suspension plate 2231. In the meantime, the volume of the first chamber 220 is shrunken and a middle space which was communicating with the convergence chamber is closed. Under this circumstance, the pressure gradient occurs to push the air in the first chamber 121 moving toward peripheral regions of the first chamber 220 and flowing downwardly through the vacant spaces 2235 of the piezoelectric actuator 223.

Please refer to FIG. 7C, which illustrates consecutive action following the action in FIG. 7B. The movable part 222a of the resonance plate 222 has returned its original position when, the piezoelectric actuator 223 has ascended at a vibration displacement to an upward position. Consequently, the volume of the first chamber 220 is consecutively shrunken that generating the pressure gradient which makes the air in the first chamber 220 continuously pushed toward peripheral regions. Meanwhile, the air continuously fed into the inlets 221a of the gas inlet plate 221 and transferred to the central cavity 221c.

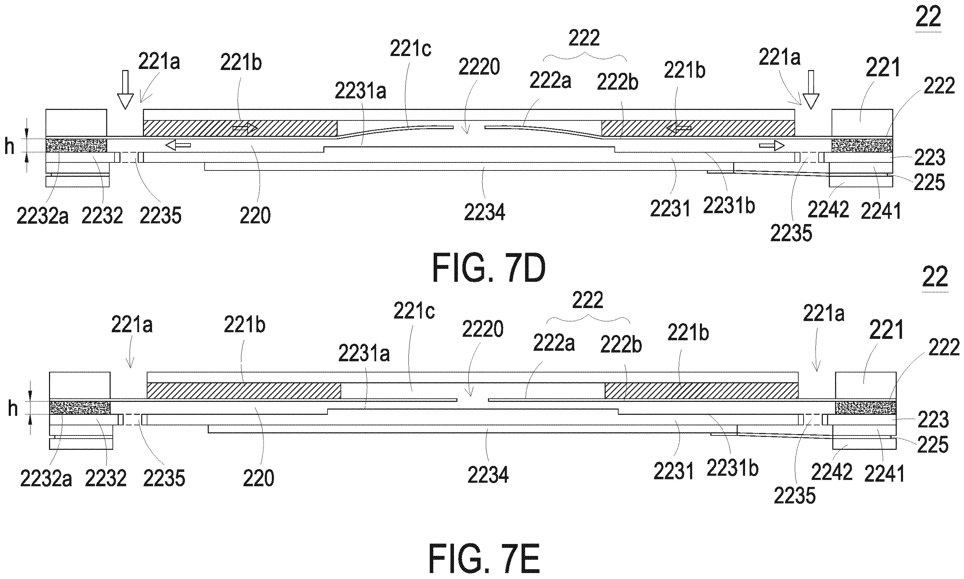

Then, as shown in FIG. 7D, the resonance plate 222 moves upwardly, which is caused by the resonance of the upward motion of the piezoelectric actuator 223. Consequently, the air is slowly fed into the inlets 221a of the gas inlet plate 221, and transferred to the central cavity 221c.

As shown in FIG. 7E, the movable part 222a of the resonance plate 222 has returned its original position. When the resonance plate 222 is vibrated along the vertical direction in the reciprocating manner, the gap h between the resonance plate 222 and the piezoelectric actuator 223 providing space for vibration of the resonance plate 222. That is, the thickness of the gap h affects the amplitude of vibration of the resonance plate 12. Consequently, a pressure gradient is generated in the fluid channels of the air pump 22 to facilitate the air to flow at a high speed. Moreover, since there is an impedance difference between the feeding direction and the exiting direction, the air can be transmitted from the inlet side to the outlet side. Moreover, even if the outlet side has a gas pressure, the air pump 22 still has the capability of pushing the air to the first airflow-guiding chamber 200 while achieving the silent efficacy.

The steps of FIGS. 7A to 7E are repeatedly done. Consequently, the ambient air is transferred by the air pump 22 from the outside to the inside.

As mentioned above, the operation of the air pump 22 can guide the air into the first airflow-guiding chamber 200 of the main body 20 and transfer the air to the second airflow-guiding chamber 201 through the communication grooves 203. The heat from the electronic component 3 is continuously removed by the introduced air. Moreover, since the air in the first airflow-guiding chamber 200 is continuously pushed to the second airflow-guiding chamber 201 through the communication grooves 203, the air in the second airflow-guiding chamber 201 is quickly moved. Moreover, the heated air is discharged to the surroundings of the air-cooling heat dissipation device 2 through the plural airflow-exiting grooves 204 of the main body 20, and thus the heat dissipating efficiency is enhanced. Under this circumstance, the performance stability and the use life of the electronic component 3 are increased.

FIG. 8 is a schematic cross-sectional view illustrating an air-cooling heat dissipation device according to a second embodiment of the present invention. Components corresponding to those of the first embodiment are designated by identical numeral references, and detailed descriptions thereof are omitted. In comparison with the air-cooling heat dissipation device 2 of FIG. 2B, the air-cooling heat dissipation device 2a of this embodiment further provides a temperature control function.

In this embodiment, the air-cooling heat dissipation device 2b comprises a control system 21 composed of a control unit 211 and a temperature sensor 212. The control unit 211 is electrically connected with the air pump 22 to control the operation of the air pump 22. The temperature sensor 212 may be disposed within the second airflow-guiding chamber 201 of the main body 20 and located near the electronic component 3 for detecting the temperature near the electronic component 3. Alternatively, the temperature sensor 212 may be attached on the electronic component 3 for detecting the temperature of the electronic component 3. The temperature sensor 212 is electrically connected with the control unit 211. After detecting the temperature of the electronic component 3, the temperature sensor 212 transmits a corresponding detecting signal to the control unit 211 so that the control unit 211 obtains the temperature of the electronic component 3. The control unit 211 determines whether the temperature of the electronic component 3 is higher than or equal to a threshold value. If the temperature of the electronic component 3 is determined higher than or equal to the threshold value, the control unit 211 issues a first control signal to the air pump 22. According to the first control signal, the air pump 22 is enabled. When the air pump 22 is enabled, the airflow is driven to cool the electronic component 3. Consequently, the heat of the electronic component 3 is dissipated away and the temperature of the electronic component 3 is decreased. Oppositely, if the temperature of the electronic component 3 is determined lower than the threshold value, the control unit 211 issues a second control signal to the air pump 22. According to the second control signal, the air pump 22 is disabled. As so, the air pump 22 is activated only when high temperature is detected, which is beneficial to prolong the life span of the air pump 22 and reduce power consumption. Moreover, since the electronic component 3 keeps operating at a suitable temperature, the stability of performance of the electronic component 3 is increased.

From the above descriptions, the present invention provides an air-cooling heat dissipation device. The air-cooling heat dissipation device is applied to various electronic devices to remove heat from electronic components of the electronic devices through creating lateral convection. Consequently, the heat dissipating efficiency is enhanced, the noise is reduced, and the performance stability and the life span of the electronic component are increased. Moreover, since it is not necessary to attach a heat sink on the electronic component, the overall thickness of the electronic device is reduced. Moreover, the air-cooling heat dissipation device also has a temperature control function. According to the temperature change of the electronic component, the operation of the air pump is correspondingly controlled. Consequently, the heat dissipating efficiency is enhanced, and the use life of the air-cooling heat dissipation device is extended.

## Claims

1. An air-cooling heat dissipation device (2, 2a) for removing heat from an electronic component (3), the air-cooling heat dissipation device (2, 2a) comprising:
a main body (20) comprising a top surface (20a), a bottom surface (20b), a first lateral wall (205a), a second lateral wall (205b), a first airflow-guiding chamber (200), a second airflow-guiding chamber (201), an introduction opening (202), plural communication grooves (203) and plural airflow-exiting grooves (204), wherein the first lateral wall (205a) and the second lateral wall (205b) are connected between the top surface (20a) and the bottom surface (20b), the first airflow-guiding chamber (200) and the second airflow-guiding chamber (201) are arranged between the first lateral wall (205a) and the second lateral wall (205b), the introduction opening (202) is formed in the top surface (20a), the first airflow-guiding chamber (200) runs through the bottom surface (20b) and is in communication with the introduction opening (202), the plural airflow-exiting grooves (204) are formed in one of the first lateral wall (205a) and the second lateral wall (205b) and in communication with the second airflow-guiding chamber (201), and the electronic component (3) is accommodated within the second airflow-guiding chamber (201);
an air pump (22) disposed on the main body (20) and sealing the edge of the introduction opening (202),
wherein when the air pump (22) is enabled, an ambient air is introduced into the first airflow-guiding chamber (200) through the introduction opening (202) and transferred to the second airflow-guiding chamber (201) through the plural communication grooves (203) so as to remove the heat from the electronic component (3), after which the air heated by the electronic component (3) is discharged through the plural airflow-exiting grooves (204);
wherein the air-cooling heat dissipation device (2, 2a) is **characterized in**:
the main body (20) is a plate structure;
the first airflow-guiding chamber (200) is formed in the plate structure;
the second airflow-guiding chamber (201) is concavely formed in the bottom surface (20b) of the plate structure;
the depths of the plural communication grooves (203) are smaller than the depth of the first airflow-guiding chamber (200) and the depth of the second airflow-guiding chamber (201);
the first airflow-guiding chamber (200) and the second airflow-guiding chamber (201) are separated from each other by a separation wall (206) and in communication with each other through the plural communication grooves (203) formed in the separation wall (206).

2. The air-cooling heat dissipation device (2, 2a) according to claim 1, wherein the air-cooling heat dissipation device (2, 2a) further comprises a supporting substrate 4, wherein the supporting substrate (4) is coupled with the bottom surface (20b) of the main body (20), and the electronic component (3) is supported on the supporting substrate (4).

3. The air-cooling heat dissipation device (2, 2a) according to claim 1,
wherein the main body (20) further comprises a receiving part (207) which is a recess concavely formed in the top surface (20a) of the main body (20) and arranged around the introduction opening (202), and the air pump (22) is fitted to the receiving part (207).

4. The air-cooling heat dissipation device (2, 2a) according to claim 1,
wherein the air pump (22) is a piezoelectric air pump.

5. The air-cooling heat dissipation device (2, 2a) according to claim 4, wherein the piezoelectric air pump comprises:
a gas inlet plate (221) comprising at least one inlet (221a), at least one convergence channel (221b) and a central cavity (221c), wherein a convergence chamber is defined by the central cavity (221c), and the at least one convergence channel (221b) corresponds to the at least one inlet (221a), wherein after the air is introduced into the at least one convergence channel (221b) through the at least one inlet (221a), the air is guided by the at least one convergence channel (221b) and converged to the convergence chamber;
a resonance plate (222) having a central aperture (2220), wherein the central aperture (2220) is aligned with the convergence chamber, wherein the resonance plate (222) comprises a movable part (222a) near the central aperture (2220); and
a piezoelectric actuator (223) aligned with the resonance plate (222), wherein a gap (h) is formed between the resonance plate (222) and the piezoelectric actuator (223) to define a first chamber (220), wherein when the piezoelectric actuator (223) is enabled, the air is fed into the air pump (22) through the at least one inlet (221a) of the gas inlet plate (221), converged to the central cavity (221c) through the at least one convergence channel (221b), transferred through the central aperture (2220) of the resonance plate (222), and introduced into the first chamber (220), wherein the air is further transferred through a resonance between the piezoelectric actuator (223) and the movable part (222a) of the resonance plate (222).

6. The air-cooling heat dissipation device (2, 2a) according to claim 5, wherein the piezoelectric actuator (223) comprises:
a suspension plate (2231) having a first surface (2231c) and a second surface (2231b), wherein the suspension plate (2231) is permitted to undergo a curvy vibration;
an outer frame (2232) arranged around the suspension plate (2231);
at least one bracket (2233) connected between the suspension plate (2231) and the outer frame (2232) for elastically supporting the suspension plate (2231); and
a piezoelectric plate (2234), wherein a length of a side of the piezoelectric plate (2234) is smaller than or equal to a length of a side of the suspension plate (2231), and the piezoelectric plate (2234) is attached on the first surface (2231c) of the suspension plate (2231), wherein when a voltage is applied to the piezoelectric plate (2234), the suspension plate (2231) is driven to undergo the curvy vibration.

7. The air-cooling heat dissipation device (2, 2a) according to claim 6, wherein the suspension plate (2231) is a square suspension plate with a bulge (2231a) formed thereon.

8. The air-cooling heat dissipation device (2, 2a) according to claim 5, wherein the piezoelectric air pump further comprises a conducting plate (225), a first insulation plate (2241) and a second insulation plate (2242), wherein the gas inlet plate (221), the resonance plate (222), the first insulation plate (2241), the conducting plate (225) and the second insulation plate (2242) are stacked on each other sequentially.

9. The air-cooling heat dissipation device (2, 2a) according to claim 1, further comprising a control system (21), wherein the control system (21) comprises:
a control unit (211) electrically connected with the air pump (22) for controlling operations of the air pump (22); and
a temperature sensor (212) electrically connected with the control unit (211) and located near the electronic component (3), wherein the temperature sensor (212) detects a temperature of the electronic component (3) and generates a corresponding detecting signal to the control unit (211),
wherein the control unit (211) obtains the temperature of the electronic component (3) according to the detecting signal, wherein if the control unit (211) determines the temperature of the electronic component (3) is higher than or equal to a threshold value, the control unit (211) enables the air pump (22) to drive the air to flow, wherein if the control unit (211) determines the temperature of the electronic component (3) is lower than the threshold value, the control unit (211) disables the air pump (22).

## Patentansprüche

1. Eine mit Luft kühlende Wärmeabfuhrvorrichtung (2, 2a) zum Abführen von Wärme von einer elektronischen Komponente (3), wobei die mit Luft kühlende Wärmeabfuhrvorrichtung (2, 2a) umfasst:
einen Hauptkörper (20), der eine obere Fläche (20a), eine untere Fläche (20b), eine erste Seitenwand (205a), eine zweite Seitenwand (205b), eine erste luftstromleitende Kammer (200), eine zweite luftstromleitende Kammer (201), eine Einführungsöffnung (202), mehrere Verbindungsnuten (203) und mehrere Luftstromaustrittsnuten (204) umfasst, wobei die erste Seitenwand (205a) und die zweite Seitenwand (205b) zwischen der oberen Fläche (20a) und der unteren Fläche (20b) verbunden sind, die erste luftstromleitende Kammer (200) und die zweite luftstromleitende Kammer (201) zwischen der ersten Seitenwand (205a) und der zweiten Seitenwand (205b) angeordnet sind, die Einführungsöffnung (202) in der oberen Fläche (20a) ausgebildet ist, die erste luftstromführende Kammer (200) durch die untere Fläche (20b) verläuft und mit der Einführungsöffnung (202) in Verbindung steht, die mehreren luftstromabführenden Nuten (204) in einer der ersten Seitenwand (205a) und der zweiten Seitenwand (205b) ausgebildet sind und mit der zweiten luftstromführenden Kammer (201) in Verbindung stehen, und das elektronische Bauteil (3) innerhalb der zweiten luftstromführenden Kammer (201) untergebracht ist;
eine Luftpumpe (22), die auf dem Hauptkörper (20) angeordnet ist und den Rand der Einführungsöffnung (202) abdichtet,
wobei, wenn die Luftpumpe (22) aktiviert ist, eine Umgebungsluft in die erste luftstromführende Kammer (200) durch die Einführungsöffnung (202) eingeführt wird und zu der zweiten luftstromführenden Kammer (201) durch die mehreren Verbindungsnuten (203) übertragen wird, um die Wärme von der elektronischen Komponente (3) zu entfernen, wonach die durch die elektronische Komponente (3) erwärmte Luft durch die mehreren luftstromabführenden Nuten (204) abgeführt wird;
wobei die mit Luft kühlende Wärmeabfuhrvorrichtung (2, 2a) **dadurch gekennzeichnet ist, dass**:
der Hauptkörper (20) eine Plattenstruktur ist;
die erste luftstromleitende Kammer (200) in der Plattenstruktur ausgebildet ist;
die zweite luftstromleitende Kammer (201) konkav in der Bodenfläche (20b) der Plattenstruktur ausgebildet ist;
die Tiefen der mehreren Verbindungsnuten (203) kleiner als die Tiefe der ersten luftstromführenden Kammer (200) und die Tiefe der zweiten luftstromführenden Kammer (201) sind;
die erste luftstromführende Kammer (200) und die zweite luftstromführende Kammer (201) durch eine Trennwand (206) voneinander getrennt sind und durch die mehreren in der Trennwand (206) ausgebildeten Verbindungsnuten (203) miteinander in Verbindung stehen.

2. Die mit Luft kühlende Wärmeabfuhrvorrichtung (2, 2a) nach Anspruch 1, wobei die mit Luft kühlende Wärmeabfuhrvorrichtung (2, 2a) ferner ein Trägersubstrat (4) umfasst, wobei das Trägersubstrat (4) mit der Bodenfläche (20b) des Hauptkörpers (20) gekoppelt ist und die elektronische Komponente (3) auf dem Trägersubstrat (4) getragen wird.

3. Die mit Luft kühlende Wärmeabfuhrvorrichtung (2, 2a) nach Anspruch 1, wobei der Hauptkörper (20) ferner ein Aufnahmeteil (207) umfasst, das eine konkav in der oberen Fläche (20a) des Hauptkörpers (20) ausgebildete und um die Einführungsöffnung (202) herum angeordnete Ausnehmung ist, und die Luftpumpe (22) an dem Aufnahmeteil (207) angebracht ist.

4. Die mit Luft kühlende Wärmeabfuhrvorrichtung (2, 2a) nach Anspruch 1, wobei die Luftpumpe (22) eine piezoelektrische Luftpumpe ist.

5. Die mit Luft kühlende Wärmeabfuhrvorrichtung (2, 2a) nach Anspruch 4, wobei die piezoelektrische Luftpumpe umfasst:
eine Gaseinlassplatte (221), die mindestens einen Einlass (221a), mindestens einen Konvergenzkanal (221b) und einen zentralen Hohlraum (221c) umfasst, wobei durch den zentralen Hohlraum (221c) eine Konvergenzkammer definiert ist und der mindestens eine Konvergenzkanal (221b) dem mindestens einen Einlass (221a) entspricht, wobei, nachdem die Luft durch den mindestens einen Einlass (221a) in den mindestens einen Konvergenzkanal (221b) eingeleitet wird, die Luft durch den mindestens einen Konvergenzkanal (221b) geführt wird und in der Konvergenzkammer konvergiert;
eine Resonanzplatte (222) mit einer zentralen Öffnung (2220), wobei die zentrale Öffnung (2220) mit der Konvergenzkammer ausgerichtet ist, wobei die Resonanzplatte (222) ein bewegliches Teil (222a) in der Nähe der zentralen Öffnung (2220) aufweist; und
einen piezoelektrischen Aktuator (223), der mit der Resonanzplatte (222) ausgerichtet ist, wobei ein Spalt (h) zwischen der Resonanzplatte (222) und dem piezoelektrischen Aktuator (223) gebildet ist, um eine erste Kammer (220) zu definieren, wobei, wenn der piezoelektrische Aktuator (223) aktiviert ist, die Luft in die Luftpumpe (22) durch den mindestens einen Einlass (221a) der Gaseinlassplatte (221) zugeführt wird, durch den mindestens einen Konvergenzkanal (221b) in den zentralen Hohlraum (221c) konvergiert, durch die zentrale Öffnung (2220) der Resonanzplatte (222) übertragen und in die erste Kammer (220) eingeleitet wird, wobei die Luft ferner durch eine Resonanz zwischen dem piezoelektrischen Aktor (223) und dem beweglichen Teil (222a) der Resonanzplatte (222) übertragen wird.

6. Die mit Luft kühlende Wärmeabfuhrvorrichtung (2, 2a) nach Anspruch 5, wobei der piezoelektrische Aktor (223) umfasst:
eine Aufhängungsplatte (2231) mit einer ersten Oberfläche (2231c) und einer zweiten Oberfläche (2231b), wobei die Aufhängungsplatte (2231) eine kurvenförmige Schwingung ausführen kann;
einem Außenrahmen (2232), der um die Aufhängungsplatte (2231) herum angeordnet ist;
mindestens eine Klammer (2233), die zwischen der Aufhängungsplatte (2231) und dem Außenrahmen (2232) verbunden ist, um die Aufhängungsplatte (2231) elastisch zu stützen; und
eine piezoelektrische Platte (2234), wobei eine Länge einer Seite der piezoelektrischen Platte (2234) kleiner oder gleich einer Länge einer Seite der Aufhängungsplatte (2231) ist, und die piezoelektrische Platte (2234) an der ersten Oberfläche (2231c) der Aufhängungsplatte (2231) angebracht ist, wobei, wenn eine Spannung an die piezoelektrische Platte (2234) angelegt wird, die Aufhängungsplatte (2231) angetrieben wird, um die gekrümmte Schwingung zu erfahren.

7. Die mit Luft kühlende Wärmeabfuhrvorrichtung (2, 2a) nach Anspruch 6, wobei die Aufhängungsplatte (2231) eine quadratische Aufhängungsplatte mit einer daran ausgebildeten Ausbuchtung (2231a) ist.

8. Die mit Luft kühlende Wärmeabfuhrvorrichtung (2, 2a) nach Anspruch 5, wobei die piezoelektrische Luftpumpe weiterhin eine leitende Platte (225), eine erste Isolationsplatte (2241) und eine zweite Isolationsplatte (2242) umfasst, wobei die Gaseinlassplatte (221), die Resonanzplatte (222), die erste Isolationsplatte (2241), die leitende Platte (225) und die zweite Isolationsplatte (2242) aufeinander gestapelt sind.

9. Die mit Luft kühlende Wärmeabfuhrvorrichtung (2, 2a) nach Anspruch 1, ferner umfassend ein Steuerungssystem (21), wobei das Steuerungssystem (21) umfasst:
eine Steuereinheit (211), die elektrisch mit der Luftpumpe (22) verbunden ist, um den Betrieb der Luftpumpe (22) zu steuern; und
einen Temperatursensor (212), der elektrisch mit der Steuereinheit (211) verbunden ist und sich in der Nähe der elektronischen Komponente (3) befindet, wobei der Temperatursensor (212) eine Temperatur der elektronischen Komponente (3) erfasst und ein entsprechendes Erfassungssignal an die Steuereinheit (211) erzeugt,
wobei die Steuereinheit (211) die Temperatur des elektronischen Bauteils (3) gemäß dem Erfassungssignal erhält, wobei, wenn die Steuereinheit (211) feststellt, dass die Temperatur des elektronischen Bauteils (3) höher oder gleich einem Schwellenwert ist, die Steuereinheit (211) die Luftpumpe (22) freigibt, um die Luft zum Strömen zu bringen, wobei, wenn die Steuereinheit (211) feststellt, dass die Temperatur des elektronischen Bauteils (3) niedriger als der Schwellenwert ist, die Steuereinheit (211) die Luftpumpe (22) deaktiviert.

## Revendications

1. Un dispositif de dissipation de chaleur à refroidissement par air (2, 2a) pour éliminer la chaleur d'un composant électronique (3), le dispositif de dissipation de chaleur à refroidissement par air (2, 2a) comprenant :
un corps principal (20) comprenant une surface supérieure (20a), une surface inférieure (20b), une première paroi latérale (205a), une deuxième paroi latérale (205b), une première chambre de guidage d'écoulement d'air (200), une deuxième chambre de guidage d'écoulement d'air (201), une ouverture d'introduction (202), plusieurs rainures de communication (203) et plusieurs rainures de sortie d'air (204), dans lequel la première paroi latérale (205a) et la deuxième paroi latérale (205b) sont connectées entre la surface supérieure (20a) et la surface inférieure (20b), la première chambre de guidage d'écoulement d'air (200) et la deuxième chambre de guidage d'écoulement d'air (201) sont disposées entre la première paroi latérale (205a) et la deuxième paroi latérale (205b), l'ouverture d'introduction (202) est formée dans la surface supérieure (20a), la première chambre de guidage d'écoulement d'air (200) traverse la surface inférieure (20b) et est en communication avec l'ouverture d'introduction (202), les multiples rainures de sortie d'air (204) étant formées dans l'une parmi la première paroi latérale (205a) et la deuxième paroi latérale (205b) et sont en communication avec la deuxième chambre de guidage d'écoulement d'air (201), et le composant électronique (3) est logé à l'intérieur de la deuxième chambre de guidage d'écoulement d'air (201) ;
une pompe à air (22) disposée sur le corps principal (20) et obturant le bord de l'ouverture d'introduction (202),
dans lequel lorsque la pompe à air (22) est activée, un air ambiant est introduit dans la première chambre de guidage d'écoulement d'air (200) à travers l'ouverture d'introduction (202) et est transféré à la deuxième chambre de guidage d'écoulement d'air (201) à travers les multiples rainures de communication (203) de manière à évacuer la chaleur du composant électronique (3), à la suite de quoi l'air chauffé par le composant électronique (3) est évacué à travers les multiples rainures de sortie d'air (204) ;
dans lequel le dispositif de dissipation de chaleur à refroidissement par air (2, 2a) est **caractérisé en ce que**
le corps principal (20) est une structure plate ;
la première chambre de guidage d'écoulement d'air (200) est formée dans la structure plate ;
la deuxième chambre de guidage d'écoulement d'air (201) est formée de manière concave dans la surface inférieure (20b) de la structure plate ;
les profondeurs des multiples rainures de communication (203) sont moindres que la profondeur de la première chambre de guidage d'écoulement d'air (200) et celle de la deuxième chambre de guidage d'écoulement d'air (201) ;
la première chambre de guidage d'écoulement d'air (200) et la deuxième chambre de guidage d'écoulement d'air sont séparées l'une de l'autre par une paroi de séparation (206) et en communication l'une avec l'autre via les multiples rainures de communication (203) formées dans la paroi de séparation (206).

2. Le dispositif de dissipation de chaleur à refroidissement par air (2, 2a) selon la revendication 1, dans lequel le dispositif de dissipation de chaleur à refroidissement par air (2, 2a) comprend en outre un substrat de support (4), dans lequel le substrat de support (4) est couplé à la surface inférieure (20b) du corps principal (20), et le composant électronique (3) est supporté sur le substrat de support (4).

3. Le dispositif de dissipation thermique à refroidissement par air (2, 2a) selon la revendication 1 , dans lequel le corps principal (20) comprend en outre une partie de réception (207) qui est un évidement formé de manière concave dans la surface supérieure (20a) du corps principal (20) et disposé autour de l'ouverture d'introduction (202), et la pompe à air (22) est montée sur la partie réceptrice (207).

4. Le dispositif de dissipation thermique à refroidissement par air (2, 2a) selon la revendication 1, dans lequel la pompe à air (22) est une pompe à air piézoélectrique.

5. Le dispositif de dissipation thermique à refroidissement par air (2, 2a) selon la revendication 4, dans lequel la pompe à air piézoélectrique comprend :
une plaque d'entrée de gaz (221) comprenant au moins une entrée (221a), au moins un canal de convergence (221b) et une cavité centrale (221c), dans laquelle une chambre de convergence est définie par la cavité centrale (221c), et le canal ou les canaux de convergence (221b) correspond(ent) à l'entrée ou aux entrées (221a), dans lequel après que l'air a été introduit dans le canal ou les canaux de convergence (221b) à travers l'entrée ou les entrées (221a), l'air est guidé par le canal ou les canaux de convergence (221b) et converge vers la chambre de convergence ;
une plaque de résonance (222) ayant une ouverture centrale (2220), dans laquelle l'ouverture centrale (2220) est alignée avec la chambre de convergence, dans laquelle la plaque de résonance (222) comprend une partie mobile (222a) près de l'ouverture centrale (2220) ; et
un actionneur piézoélectrique (223) aligné avec la plaque de résonance (222), dans lequel un espace (h) est formé entre la plaque de résonance (222) et l'actionneur piézoélectrique (223) pour définir une première chambre (220), dans lequel lorsque l'actionneur piézoélectrique l'actionneur (223) est activé, l'air est introduit dans la pompe à air (22) par l'entrée ou les entrées (221a) de la plaque d'admission de gaz (221), converge vers la cavité centrale (221c) par le canal ou les canaux de convergence (221b), est transféré à travers l'ouverture centrale (2220) de la plaque de résonance (222), et introduit dans la première chambre (220), dans lequel l'air est en outre transféré par résonnance résonance entre l'actionneur piézoélectrique (223) et la partie mobile (222a) de la plaque de résonance (222).

6. Le dispositif de dissipation thermique à refroidissement par air (2, 2a) selon la revendication 5, dans lequel l'actionneur piézoélectrique (223) comprend :
une plaque de suspension (2231) ayant une première surface (2231c) et une seconde surface (2231b), dans laquelle la plaque de suspension (2231) est autorisée à subir une vibration incurvée ;
un cadre extérieur (2232) disposé autour de la plaque de suspension (2231) ;
au moins un support (2233) connecté entre la plaque de suspension (2231) et le cadre extérieur (2232) pour supporter élastiquement la plaque de suspension (2231); et
une plaque piézoélectrique (2234), dans laquelle une longueur d'un côté de la plaque piézoélectrique (2234) est inférieure ou égale à une longueur d'un côté de la plaque de suspension (2231), et la plaque piézoélectrique (2234) est fixée sur la première surface (2231c) de la plaque de suspension (2231), dans laquelle lorsqu'une tension est appliquée à la plaque piézoélectrique (2234), la plaque de suspension (2231) est entraînée pour subir la vibration courbe.

7. Le dispositif de dissipation thermique à refroidissement par air (2, 2a) selon la revendication 6, dans lequel la plaque de suspension (2231) est une plaque de suspension carrée avec un renflement (2231a) qui y est formé dessus.

8. Le dispositif de dissipation thermique à refroidissement par air (2, 2a) selon la revendication 5, dans lequel la pompe à air piézoélectrique comprend en outre une plaque conductrice (225), une première plaque isolante (2241) et une seconde plaque isolante (2242), dans lequel la plaque d'entrée de gaz (221), la plaque de résonance (222), la première plaque isolante (2241), la plaque conductrice (225) et la deuxième plaque isolante (2242) sont empilées les unes sur les autres de manière séquentielle.

9. Le dispositif de dissipation thermique à refroidissement par air (2, 2a) selon la revendication 1, comprenant en outre un système de commande (21), dans lequel le système de commande (21) comprend :
une unité de commande (211) connectée électriquement à la pompe à air (22) pour commander les opérations de la pompe à air (22) ; et
un capteur de température (212) connecté électriquement à l'unité de commande (211) et situé à proximité du composant électronique (3), dans lequel le capteur de température (212) détecte une température du composant électronique (3) et génère un signal de détection correspondant pour l'unité de commande (211),
dans lequel l'unité de commande (211) obtient la température du composant électronique (3) selon le signal de détection, dans lequel si l'unité de commande (211) détermine que la température du composant électronique (3) est supérieure ou égale à une valeur seuil , l'unité de commande (211) permet à la pompe à air (22) de faire circuler l'air, dans lequel si l'unité de commande (211) détermine que la température du composant électronique (3) est inférieure à la valeur seuil, l'unité de commande (211) désactive la pompe à air (22).
